**Europäisches Patentamt**

**European Patent Office**

**Office européen des brevets**

(19)

(11) Publication number: **0 202 477**
**A2**

(12) **EUROPEAN PATENT APPLICATION**

(21) Application number: **86105334.6**

(22) Date of filing: **17.04.86**

(51) Int. Cl.⁴: **H 01 L 21/285**
**H 01 L 21/60**

(30) Priority: **24.04.85 US 726747**

(43) Date of publication of application:
**26.11.86 Bulletin 86/48**

(84) Designated Contracting States:
**DE FR GB NL**

(71) Applicant: **GENERAL ELECTRIC COMPANY**
**1 River Road**
**Schenectady New York 12305(US)**

(72) Inventor: **Chow, Tat-Sing Paul**
**708 Hampshire Seat**
**Schenectady New York 12309(US)**

(72) Inventor: **Baliga, Bantval Jayant**
**1218 Viewmont Drive**
**Schenectady New York 12309(US)**

(72) Inventor: **Love, Robert Paul**
**49 Hillcrest Avenue**
**Schenectady New York 12304(US)**

(74) Representative: **Catherine, Alain et al,**
**General Electric - Deutschland Munich Patent Operations**
**Frauenstrasse 32**
**D-8000 München 5(DE)**

(54) **Method of forming an electrical short circuit between adjoining regions in an insulated gate semiconductor device.**

(57) A method of forming an electrical short circuit between adjoining regions of an insulated gate semiconductor device uses retained portions of insulating layers formed over gate electrodes as an etching mask. The insulating layers are formed over the exposed surfaces of the insulated gate device, including the gate electrodes, and are then selectively removed to leave the retained portions covering the gate electrode top surfaces and sidewalls while exposing selected areas of a semiconductor substrate. The retained portions of the insulating layers are then used as an etching mask to etch away selected portions of the adjoining regions in the semiconductor substrate and expose a junction therebetween. The electrical short circuit is subsequently formed at the exposed junction.

FIG. 6

0202477

## METHOD OF FORMING AN ELECTRICAL SHORT CIRCUIT BETWEEN ADJOINING REGIONS IN AN INSULATED GATE SEMICONDUCTOR DEVICE

The present invention relates in general to semiconductor devices and in particular to a method of forming an electrical short circuit between adjoining regions in an insulated gate semiconductor device.

Background of the Invention

A typical insulated gate device is the insulated-gate transistor (IGT), a device capable of controlling relatively high levels of forward current with a relatively low bias voltage applied to its gate electrode. As such, IGTs find many applications in the fields of power generation and power control.

A typical IGT comprises four adjacent semiconductor regions of alternate conductivity types (eg. a PNPN structure) which may be considered to form a pair of inherent bipolar transistors that are regeneratively coupled to form an inherent thyristor. In the the IGT, the operating characteristics of the inherent bipolar transistors can produce certain operating conditions that must be taken into consideration. Specifically, when a threshold forward current level is exceeded in the IGT device, its inherent thyristor latches into an "on" or conducting state, and control of the forward current through biasing of the gate electrode (i.e. gate control) is lost. When such a loss of gate control occurs, actions external to the device must be taken to limit or stop the forward current flow, so as to insure against causing destruction of the device.

Analysis of the operation of the inherent bipolar transistors reveals the physical mechanism which causes the IGT to latch on and lose gate control. In an IGT with a P-conductivity type base region, an increase in the level of the forward electron current flow causes an increase in the level of a parasitic hole current in a base region, which in turn causes a lateral voltage drop along the base region adjacent an emitter-base junction. When this lateral voltage drop exceeds the inherent emitter-base junction potential, bipolar action is initiated at this junction, i.e. the emitter commences injection of current carriers across the emitter-base junction, and the forward current gain of an associated, inherent bipolar transistor increases. In a manner well known in the art, when the sum of the forward current gains of the pair of regeneratively coupled, inherent bipolar transistors approaches unity, the inherent thyristor latches on, causing the loss of gate control described above.

It is known in the art that the current control characteristics of the IGT can be improved by decreasing the magnitude of the lateral voltage drop along the emitter-base junction. That is, decreasing this lateral voltage drop increases the level of forward current which the IGT can gate control. One known method of decreasing this lateral voltage drop is to increase the depth of the base region, which has the effect of decreasing the resistance of the base region to the parasitic hole current flow. This method, however, produces a long MOS channel and a high resistance device. An alternative method of decreasing the lateral voltage drop along the emitter-base junction is to deposit a high concentration of impurities deeply into the base region. This method, however, requires the use of additional, closely aligned masks.

Another type of insulated gate device which exhibits loss of gate control similar to that of the IGT is the insulated-gate field-effect transistor (IGFET), commonly referred to as a metal-oxide-semiconductor field-effect transistor (MOSFET). As in the IGT, the IGFET device includes a single, inherent bipolar transistor susceptible to being biased into conduction when a lateral voltage drop along a source-body junction exceeds an inherent junction potential. When this conduction occurs, gate control of the forward current is lost. Methods analogous to those recited above can be used to decrease the level of this lateral voltage drop and improve the current control characteristics of the IGFET.

### Objects of the Invention

A principal object of the present invention is to provide a new and improved method for forming an electrical short circuit between adjoining regions of a semiconductor device.

Another object of the present invention is to provide a method for forming an electrical short circuit between adjoining regions of a semiconductor device which produces a physically short base region portion adjacent an emitter-base junction having a resultantly small lateral voltage drop.

Yet another object of the present invention is to provide a method for forming an electrical short circuit between adjoining regions of a semiconductor device which does not require the use of additional, closely aligned etching masks.

A further object of the present invention is to provide a method for forming an electrical short circuit between adjoining regions of a semiconductor device which is compatible with other steps in the device construction process and requires a minimum of additional process steps.

<u>Summary of the Invention</u>

The foregoing objects of the invention are achieved through the use of a new and improved method of forming an electrical short circuit between adjoining first and second regions of an insulated gate semiconductor device. The electrical short circuit, when formed in accordance with the present invention, clamps the lateral voltage drop at the junction between the regions to zero at the point of the short, produces a shorter second region portion adjacent the junction, and provides a resultantly lower lateral voltage drop. Forming the short circuit in accordance with the present invention has the net effect of improving the current control characteristics of the devices in the manner described herein.

In the preferred embodiment of the invention, illustrated and described herein, the method is implemented on an insulated gate semiconductor device comprising, in a semiconductor substrate having a major surface, a first region of a first conductivity type and a second region of a second conductivity type overlying said first region and forming a junction therewith. The second region includes a top surface which comprises a portion of the major surface of the substrate. The insulated gate semiconductor device further comprises at least two electrically connected electrodes, each electrode being spaced from the major surface of the semiconductor substrate. Each of the electrodes includes a top surface and at least one sidewall, the sidewalls of the respective electrodes being in opposed, laterally spaced relation. Each of the electrodes overlies a respective, different portion of the top surface of the second region such that each of the electrode sidewalls overlies the top surface of the second region.

In accordance with the present invention, respective portions of a first insulating layer are formed over the top surfaces of the electrodes, each of the first insulating layer portions including a sidewall substantially in registry with the sidewall of its respective, underlying electrode, and a top surface. A conformal second insulating layer is then formed over the portion of the semiconductor device between the sidewalls of the electrodes, over the sidewalls of the electrodes and over the sidewalls and top surfaces of the first insulating layer portions. This second insulating layer is then selectively removed, preferably using a directional etchant, to leave retained portions thereof, herein called spacers, covering the sidewalls of the electrodes and first insulating layer portions. These spacers are used as part of an etching mask, an etchant being applied between the spacers to selectively remove parts of the first and second regions and create an exposed junction edge. A first electrically conductive layer is then formed at the exposed edge of the junction to form an electrical short circuit between the first and second regions.

The invention is applied in a substantially identical manner to both IGT and IGFET devices. In either device, after the etching step is completed, dopant impurities of the first conductivity type can optionally be deposited below the surfaces of the semiconductor device exposed by the etching step to deepen the underlying region.

It will thus be appreciated that the method which is the subject of the present invention allows an electrical short circuit to be precisely formed without requiring the use of additional, closely aligned masks. Further, the use of the spacers increases the overlain, unetched portion of the second region sufficiently to reduce the degree of anisotropy (i.e. directionality) required of the etchant, while simultaneously producing a precisely positioned electrical short circuit and a physically short base region adjacent the emitter-base junction, large portions of the base region having been removed by the etching step.

~~Brief Description of the Drawings~~

While the specification concludes with claims defining the features of the invention that are regarded as novel, it is believed that the invention, together with further objects thereof, will be better understood from a consideration of the following description in conjunction with the drawing Figures, in which:

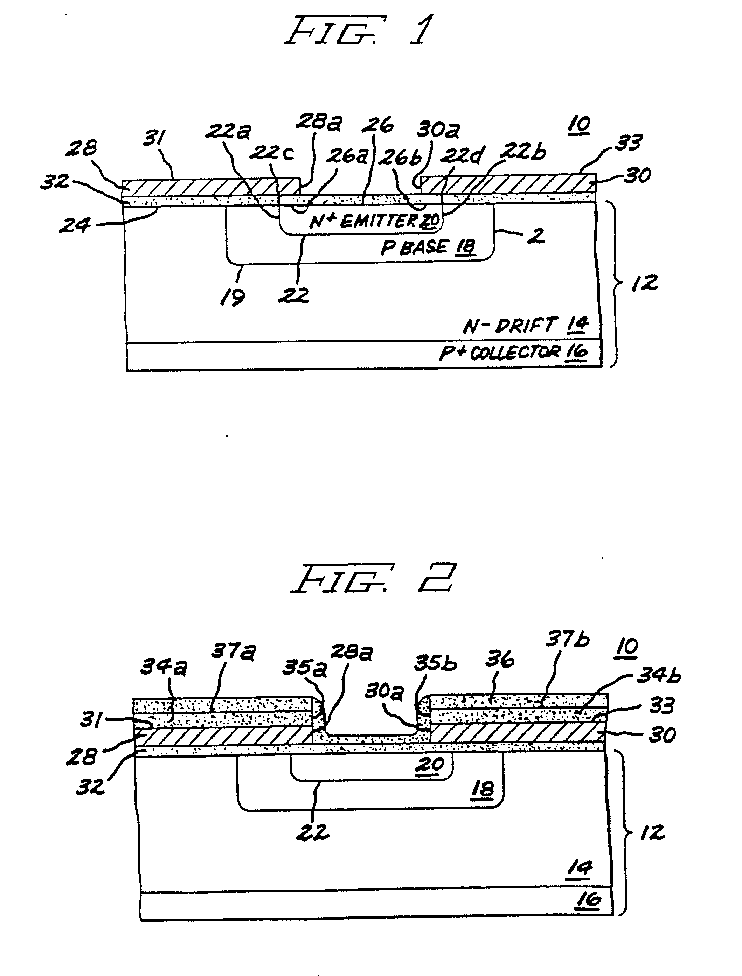

Figures 1 - 6 show cross sections of an IGT device and illustrate successive steps in a method of forming an electrical short circuit in accordance with a preferred embodiment of the invention.

### Detailed Description

Referring now to the drawings, Figure 1 shows a representative portion of an insulated gate transistor (IGT) structure 10 including a semiconductor substrate 12 comprising four successive, adjoining semiconductor regions of alternate conductivity types. An N- (i.e. lightly doped, N conductivity type) drift region 14 overlies a P+ (i.e. highly doped, P conductivity type) collector region 16, and is in turn overlain by a P (i.e. moderately doped, P conductivity type) base region 18. Base region 18 and drift region 14 adjoin each other so as to form a base-drift junction indicated at 19. An N+ (i.e. highly doped, N conductivity type) emitter region 20 overlies base region 18 and forms an emitter-base junction 22 therewith. Junction 22 has a generally U-shaped cross-sectional configuration, including a pair of legs, 22a and 22b, each of which terminates in a respective end, indicated at 22c and 22d, at a major surface 24 of substrate 12. Emitter region 20 includes a top surface 26 which forms a portion of major substrate surface 24 and is bounded on two sides by emitter-base junction legs 22a and 22b. A pair of gate electrodes 28 and 30, electrically connected at a remote location (not shown) and each preferably having the shape of a mesa, are spaced from major surface 24 of substrate 12 by an insulating layer 32 of silicon dioxide. Each gate electrode 28 and 30 has a sidewall, indicated at 28a and 30a, respectively, the respective sidewalls being in opposed, laterally spaced relation. Each gate electrode further includes a top surface, the two top surfaces being indicated respectively at 31 and 33. As illustrated, gate electrode 28 overlies emitter-base junction leg 22a and a portion 26a of top surface 26 of emitter region 20 such that sidewall 28a overlies top surface 26. In a similar manner, gate electrode 30 overlies junction leg 22b and a portion 26b of top surface 26 such that sidewall 30a also overlies the top surface of emitter region 20.

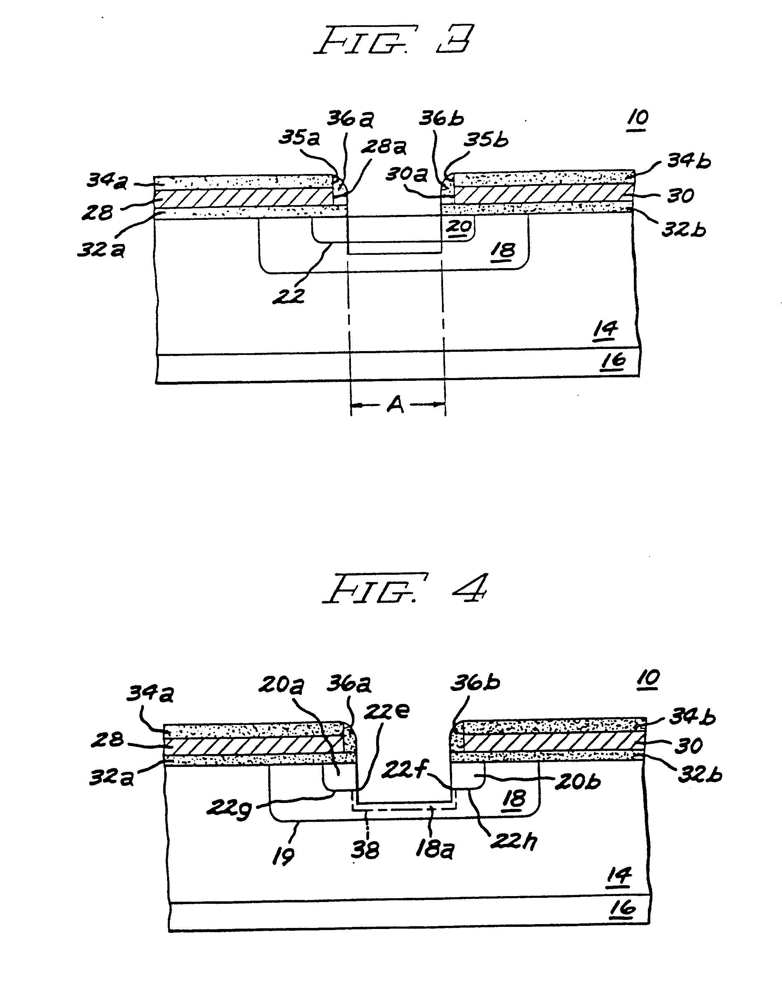

In accordance with the present invention, a first silicon dioxide layer is formed as separate layer portions, indicated at 34a and 34b of Figure 2, over respective top surfaces 31 and 33 of gate electrodes 28 and 30. These layer portions may be formed for example by the process of low pressure chemical vapor deposition (LPCVD), a process well known in the art. Layer portion 34a includes a top surface 37a and a sidewall 35a which is in substantial registry with sidewall 28a of gate electrode 28. Layer portion 34b includes a top surface 37b and a sidewall 35b which is in substantial registry with sidewall 30a of gate electrode 30.

Next, a conformal (i.e. a uniform thickness) second silicon dioxide layer, indicated at 36 in Figure 2, is formed over the portion of semiconductor substrate 12 between sidewalls 28a and 30a of the gate electrodes, over the sidewalls of the gate electrodes, and over the sidewalls and top surfaces of first silicon dioxide layer portions 34a and 34b. Silicon dioxide layer 36 may be formed, for example, by the LPCVD process cited above.

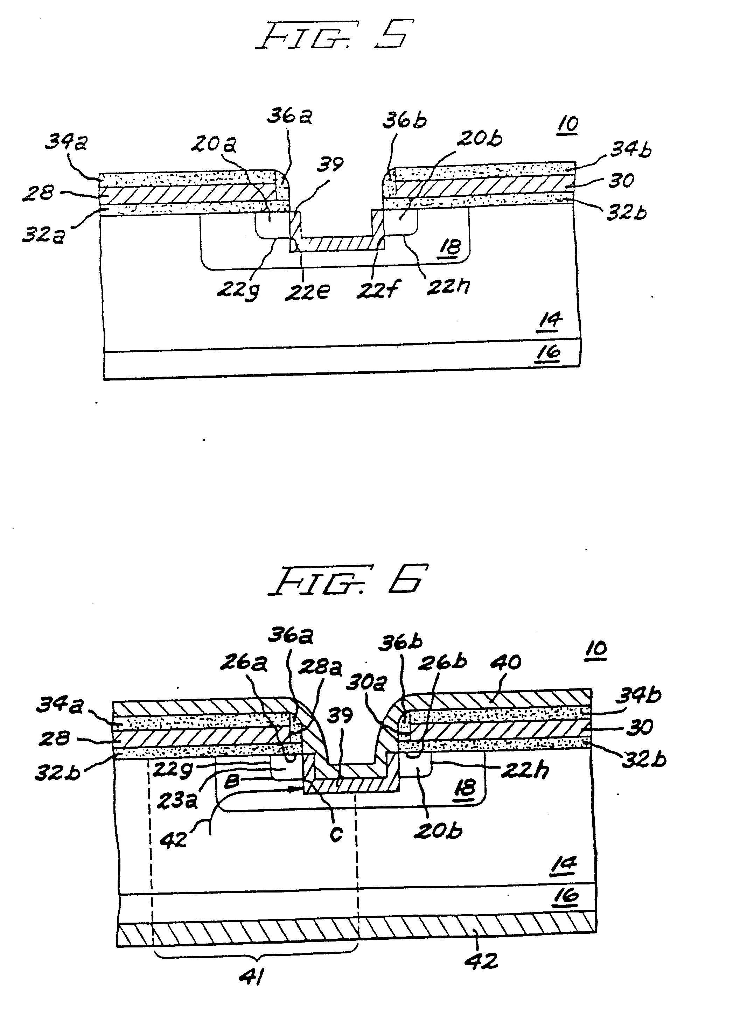

Silicon dioxide layer 36 is then selectively removed, for example by directing an anisotropic etchant such as a radio frequency plasma of trifluoromethane and helium ($CHF_3$/He) or a radio frequency plasma of tetrafluoromethane and hydrogen ($CH_4$/$H_2$) downwardly on device 10 to leave two retained portions of layer 36, herein called spacers and indicated at 36a and 36b, respectively, in Figure 3. Spacer 36a is seen to cover sidewalls 28a and 35a, while spacer 36b covers sidewalls 30a and 35b. This anisotropic etchant further removes the part of insulating layer 32 situated between the spacers, leaving insulating layer portions 32a and 32b and exposing the semiconductor surface portion designated A in Figure 3.

An anisotropic etchant, for example HCl/$SF_6$ plasma, is then applied to device 10. This anisotropic etchant is selected both for its anisotropic properties and its ability to etch silicon faster than silicon dioxide. In this manner, silicon dioxide layer portions 34a and 34b and spacers 36a and 36b together act as an etching mask. This mask directs the anisotropic etchant downward between spacers 36a and 36b, i.e. into the semiconductor surface portion designated A in Figure 3, to selectively remove parts of the emitter and base regions. A pair of exposed edges of emitter-base junction 22 are thus created, the exposed junction edges being intermediate legs 22a and 22b, and indicated at 22e and 22f in Figure 4.

At this point in the process, P conductivity type impurities are optionally introduced below the surfaces of substrate 12 which are exposed by the etching, and preferably, selectively into base region 18. These impurities form a P+ region designated in phantom at 38. This deposition can function to create a good ohmic contact between base region 18 and a later applied electrode. Further, it can function to limit the vertical extent of a depletion region developed in drift region 14 during a forward blocking mode of operation of IGT device 10, and prevent the depletion region from punching through the junction 19. The P+ doping step is typically performed by implantation with a dosage of about $10^{12} - 10^{13}$ dopant atoms per square centimeter to achieve a maximum surface impurity concentration of about $10^{17}$ dopant atoms per cubic centimeter.

As illustrated, the etching of the semiconductor region has the effect of altering the structure of emitter region 20, emitter region 20 now comprising emitter region portions 20a and 20b. Additionally, emitter-base junction 22 has also been altered by the etching so as to now comprise two sections, the sections being indicated respectively at 22g and 22h.

Upon completion of the etching, a first electrically conductive layer, indicated at 39 in Figure 5 and comprising for example a metallic material such as titanium, is formed over exposed edges 22e and 22f of the emitter-base junction, and over the exposed surfaces of the base and emitter regions between spacers 36a and 36b. First electrically conductive layer 39 is formed, for example, by conformally depositing the titanium over the surface of structure 10, annealing the structure at a temperature at which the metal reacts with the silicon to form a metal silicide but does not react with the silicon dioxide, and thereafter selectively removing the excess metal. Alternatively, the first conductive layer 39 can be formed by selective chemical vapor deposition of a metal such as tungsten onto the exposed silicon surfaces.

To complete the process, an emitter electrode comprising a second electrically conductive layer indicated at 40 in Figure 6, and for example comprising a metallic material such as aluminum, is conformally deposited over the exposed surfaces of first electrically conductive layer 39, spacers 36a and 36b, and the top surfaces of first oxide layer portions 34a and 34b. Second electrically conductive layer 40 can be formed, for example, by sputtering of aluminum, a process well known in the art. A collector electrode 44 is formed on the lowermost-illustrated surface of P+ collector region 16 at any convenient time during the process of fabricating device 10.

As will be appreciated from a consideration of the above-described Figures, an important advantage of the present invention is that it uses edges 28a and 30a of gate electrodes 28 and 30, respectively, in masking the area to be etched, and thus does not require the use of additional, closely-aligned masks employed in the prior art. Further, the inventive method allows the electrical short circuit to be formed within the distance A indicated in Figure 3. Distance A is typically much shorter for an electrical short circuit formed in accordance with the method of the present invention than for an electrical short circuit formed according to the prior art. Hence, the method of the present invention allows more electrical short circuits, and thus more associated structure, to be formed in a given area of semiconductor substrate.

It will also be appreciated that the spacers have the effect of very slightly increasing the area of surface portions 26a and 26b of emitter region 20 which are overlain by etchant resistant material. This allows the use of a simpler, less anisotropic etchant to remove portions of the base and emitter regions, without the risk of accidentally etching away the entire emitter region. As illustrated in Figure 6, the spacers also function as electrical insulators between second electrically conductive layer 40 and the sidewalls 28a and 30a of the respective gate electrodes.

The resultant operational advantages achieved through the use of the inventive method will best be understood with reference to Figure 6. It is to be understood that the portion of IGT structure 10 situated above a bracket indicated at 41 constitutes a vertical cell, the structure of which is repeated substantially identically throughout the lateral length of the device as viewed in Figure 6. The relevant characteristics of the IGT structure will, therefore, be described with respect to the single, indicated cell, all such cells typically operating in a substantially identical manner.

As is known in the art, base region 20a, emitter region 18 and drift region 14 together constitute a first, inherent, PNP type bipolar transistor, while the emitter region, drift region and collector region 16 together constitute a second, inherent, NPN type bipolar transistor. By the nature of their construction, these two transistors are regeneratively coupled to form an inherent thyristor.

As is further known in the art, and will thus be described herein only generally, when the IGT is conducting a forward electron current between emitter region 20a and collector region 16, a parasitic hole current flow is developed along a path indicated by arrow 42. There being some resistance in base region 18 adjacent junction section 22g, this parasitic hole current flow creates a lateral voltage drop in the base region along this emitter-base junction section between the points designated B and C. When this lateral voltage drop exceeds the inherent potential of the emitter-base junction (approximately 0.7 volts for silicon), the junction becomes forward biased, the inherent thyristor described above latches on, and the IGT loses gate control of the forward current. When the electrical short circuit between base region 18 and emitter region 20a is formed by metallic layer 39 in accordance with the present invention, the voltage at point C is clamped to zero. Further, the portion of base region 18 retained between points B and C has a short lateral dimension, decreasing the resistance to the hole current flow and thus inhibiting the development of a large, lateral voltage drop.

The invention is applied to an IGFET device (not shown) in a substantially identical manner, with the exception that P-conductivity type collector region 16 is replaced with an N-conductivity type drain region. The overlying emitter, base and drift regions thus form a single, inherent, NPN type bipolar transistor susceptible to conduction when the lateral voltage drop exceeds the inherent junction potential. This substitution of the IGFET drain region for the IGT collector region has no effect on the implementation of the inventive method, and the resultant electrical short circuit functions in substantially the identical manner described hereinabove, i.e. to decrease the magnitude of the lateral voltage drop along junction 22g and hence suppress forward biasing of the junction.

It will be obvious to those skilled in the art that the emitter, base and drift regions of an IGT correspond to the source, body and drift regions, respectively, of an IGFET. Similarly, the base, emitter and collector electrodes of an IGT correspond to the gate, source and drain electrodes, respectively, of an IGFET. Accordingly, the terms are used interchangeably herein, and references to any of these terms in the Claims is intended to include its equivalent. Further, while the invention has been described with respect to its application to IGT and IGFET devices, it will be appreciated that it is applicable to all insulated gate devices having substrate and electrode structural configurations which can be used to implement the steps described herein, and which would benefit from the formation of such an electrical short circuit at a predetermined point along a junction thereof.

It will be further obvious to those skilled in the art that, while semiconductor regions of selected conductivity types have been described in the preferred embodiment of the invention, the invention is not so limited and is equally applicable to devices having semiconductor regions of opposite conductivity types in which the hole and electron current carrier flows are reversed. Further, while specific processes and material types are described and illustrated herein, they are selected for specific physical characteristics and intended to be exemplary, and thus the scope of the Claims is intended to include equivalents. More specifically, silicon dioxide layers 32, 34 and 36 are selected for their insulating properties described hereinabove, and can, for example, comprise in the alternative layers of silicon nitride. These insulating layers can further comprise sublayers of various insulating materials.

~~While a preferred embodiment of the invention~~ has been illustrated and described, it will be clear that the invention is not so limited. Numerous modifications, changes, variations, substitutions and equivalents will occur to those skilled in the art without departing from the spirit and scope of the present invention. Accordingly, it is intended that the invention herein be limited only by the scope of the ~~appended claims~~.

0202477

-16-                    RD-14,987


~~What is claimed is:~~        — CLAIMS —

1. A method of forming an electrical short
circuit between adjoining regions of a semiconductor
device; said semiconductor device comprising, in a
semiconductor substrate having a major surface, a first
region of a first conductivity type and a second region
of a second conductivity type adjoining said first
region and forming a junction therewith; said second
region including a top surface comprising a portion of
said major surface of said semiconductor substrate; said
semiconductor device further comprising at least two
electrically connected electrodes, each of said
electrodes being spaced from said major surface of said
semiconductor substrate; each of said electrodes having
a top surface and a sidewall, the sidewalls of
the respective electrodes being in opposed, laterally
spaced relation; each of said electrodes overlying a
respective, different portion of said top surface of
said second region whereby each of said sidewalls of
said electrodes overlies said top surface of said second
region;
                said method comprising the steps of:
                forming respective portions of a first
insulating layer over said top surfaces of said
electrodes, each of said first insulating layer portions
including a sidewall substantially in registry with the
sidewall of its respective underlying electrode, and a
top surface;
                forming a conformal second insulating layer
over the portion of said semiconductor device between
said sidewalls of said electrodes, over said sidewalls

0202477

of said electrodes and over said sidewalls and top surfaces of said first insulating layer portions; selectively removing part of said second insulating layer to leave retained portions thereof covering said sidewalls of said electrodes and said sidewalls of said first insulating layer portions; selectively etching said semiconductor device utilizing said first insulating layer portions and said retained portions of said second insulating layer as etching masks to remove parts of said first and second regions and expose an edge of said junction; and forming an electrically conductive layer at said exposed edge of said junction to form thereat an electrical short circuit between said first and second regions.

2. The method of Claim 1 wherein said semiconductor substrate comprises silicon and the step of forming said electrically conductive layer comprises forming a layer of metal on said silicon and annealing said device at a temperature at which said metal forms a silicide with said silicon.

3. The method of Claim 1 wherein the step of forming said electrically conductive layer comprises forming said layer by selective chemical vapor deposition of metal.

4. The method of Claim 1 wherein said second insulating layer is selectively removed by the application thereto of a directional etchant.

0202477

-18-                    RD-14,987

5.   The method of Claim 4 wherein said
directional etchant comprises a radio frequency plasma
of tetrafluoromethane and hydrogen or trifluoromethane
and helium.

6.   The method of Claim 4 wherein:
said junction has a generally U-shaped,
cross-sectional configuration including a pair of legs
each terminating in a respective end at said major
surface of said semiconductor substrate;
said top surface of said second region is
bounded on two sides by said respective ends of said
pair of junction legs; and
each of said electrodes overlies a respective
one of said junction legs whereby said exposed junction
edge is created intermediate said pair of junction
legs.

7.   The method of Claim 6 wherein:
each of said first and second regions
comprises silicon semiconductor material;
said first insulating layer comprises silicon
nitride or silicon dioxide; and
said second insulating layer comprises silicon
nitride or silicon dioxide.

8.   The semiconductor device including an
electrical short circuit formed by the method of
Claim 1.

9. The semiconductor device including an electrical short circuit formed by the method of Claim 6.

10. The semiconductor device including an electrical short circuit formed by the method of Claim 7.

11. A method of forming an electrical short circuit between adjoining regions of a semiconductor device; said semiconductor device comprising, in a semiconductor substrate having a major surface, a drift region of a first conductivity type, a base region of a second conductivity type adjoining said drift region, and an emitter region of said first conductivity type adjoining said base region and forming an emitter-base junction therewith; said emitter-base junction having a generally U-shaped, cross-sectional configuration including a pair of legs each terminating in a respective end at said major surface of said semiconductor substrate; said emitter region including a top surface comprising a portion of said major surface of said semiconductor substrate bounded on two sides by said respective ends of said pair of emitter-base junction legs; said semiconductor device further comprising at least two electrically connected gate electrodes, each of said gate electrodes being spaced from said major surface of said semiconductor substrate; each of said gate electrodes having a top surface and a sidewall, the sidewalls of the respective gate electrodes being in opposed, laterally spaced relation; each of said gate electrodes overlying a respective single leg of said pair of emitter-base junction legs, whereby each of said sidewalls of said gate electrodes overlies said top surface of said emitter region;

said method comprising the steps of:

forming respective portions of a first insulating layer over said top surfaces of said gate electrodes, each of said first insulating layer portions including a sidewall substantially in registry with the sidewall of its respective underlying gate electrode, and a top surface;

forming a conformal second insulating layer over the portion of said semiconductor device between said sidewalls of said gate electrodes, over said sidewalls of said gate electrodes and over said sidewalls and top surfaces of said first insulating layer portions;

selectively removing part of said second insulating layer to leave retained portions thereof covering said sidewalls of said gate electrodes and said sidewalls of said first insulating layer portions;

selectively etching said semiconductor device utilizing said first insulating layer portions and said retained portions of said second insulating layer as etching masks to remove parts of said emitter and base regions and expose an edge of said emitter-base junction intermediate said pair of legs thereof; and

forming a first electrically conductive layer at said exposed edge of said emitter-base junction to form thereat an electrical short circuit between said emitter and base regions.

12.   The method of Claim 11 wherein said semiconductor substrate comprises silicon and the step of forming a first electrically conductive layer comprises forming a layer of metal on said silicon and annealing said device at a temperature at which said metal forms a silicide with said silicon.

13.   The method of Claim 11 wherein the step of forming said first electrically conductive layer comprises forming said layer by selective chemical vapor deposition of metal.

14.   The method of Claim 11 wherein said second insulating layer is selectively removed by the application thereto of a directional etchant.

15.   The method of Claim 14 wherein said directional etchant comprises a radio frequency plasma of tetrafluoromethane and hydrogen or trifluoromethane and helium.

16.   The method of Claim 14 wherein:
said first electrically conductive layer covers the exposed surfaces of said semiconductor device between said retained portions of said second insulating layer; and further comprising the step of:
forming a second electrically conductive layer over the exposed surfaces of said first electrically conductive layer, said first insulating layer portions, and said retained portions of said second insulating layer.

17.  The method of Claim 16 wherein:
said base, emitter and drift regions each comprise silicon semiconductor material; said first insulating layer comprises silicon nitride or silicon dioxide; and said second insulating layer comprises silicon nitride or silicon dioxide.

18.  The method of Claim 11 and further including the step of: introducing dopant impurities of said second conductivity type below the surfaces of said semiconductor device exposed by said etching step.

19.  The method of Claim 18 wherein said semiconductor substrate comprises silicon and the step of forming said first electrically conductive layer comprises forming a layer of metal on said silicon and annealing said device at a temperature at which said metal forms a silicide with said silicon.

20.  The method of Claim 18 wherein the step of forming said first electrically conductive layer comprises forming said layer by selective chemical vapor deposition of metal.

21.  The method of Claim 18 wherein said second insulating layer is selectively removed by the application thereto of a directional etchant.

22.  The method of Claim 21 wherein said directional etchant comprises a radio frequency plasma of tetrafluoromethane and hydrogen or trifluoromethane and helium.

23. The method of Claim 21 wherein:
    said first electrically conductive layer covers the exposed surfaces of said semiconductor device between said retained portions of said second insulating layer; and further comprising the step of
    forming a second electrically conductive layer over the exposed surfaces of said first electrically conductive layer, said first insulating layer portions, and said retained portions of said second insulating layer.

24. The method of Claim 23 wherein:
    said base, emitter and drift regions each comprise silicon semiconductor material;
    said first insulating layer comprises silicon nitride or silicon dioxide; and
    said second insulating layer comprises silicon nitride or silicon dioxide.

25. The semiconductor device including an electrical short circuit formed by the method of Claim 16.

26. The semiconductor device including an electrical short circuit formed by the method of Claim 17.

27.   The semiconductor device including an
electrical short circuit formed by the method
of Claim 18.

28.   The semiconductor device including an
electrical short circuit formed by the method
of Claim 23.

29.   The semiconductor device including an
electrical short circuit formed by the method
of Claim 24.

INVENTOR *T. P. Chow et al.*
SHEET *1* OF *3* BY *G.E.T.*
INDEX *20.2168* X *0.92517*

0202477

1/3

## FIG. 1

N+ EMITTER *20*

P BASE *18*

N- DRIFT *14*

P+ COLLECTOR *16*

## FIG. 2

G. E. DOCKET RD-14987
INVENTOR T.P. CHOW et al
SHEET 2 OF 3 BY G.E.T.
INDEX 20-8169 X 09-8517

0202477

2/3

*FIG. 3*

*FIG. 4*

*FIG. 5*

*FIG. 6*